# EUROPEAN PATENT APPLICATION

(11) **EP 1 217 695 A2**
(43) Date of publication of application: **26.06.2002**
(21) Application number: 01126993.3
(22) Date of filing: 14.11.2001
(51) Int. Cl.: H01R 12/10

(54) **Flat flexible circuit interconnection**

(30) Priority: 21.12.2000 US 745457
(71) Applicant: MOLEX INCORPORATED, Lisle, IL 60532 (US)
(72) Inventor: Fuerst, Robert M., West Bloomfield, Michigan 48324 (US); Joshi, Prashat, Auburn Hills, Michigan 48326 (US)
(74) Representative: Blumbach, Kramer & Partner GbR

(57) **Abstract**

A system (10) and method are provided for interconnecting the generally parallel conductors (18) of a pair of flat circuits (12,14) out of sequential order relative to each other. The system includes a pair of flat circuits (12,14) each having a plurality of generally parallel conductors (18) covered by a dielectric film (20). A pattern of windows (24) are formed in the film (24) of each circuit (12,14) to expose the conductors at different locations longitudinally thereof. The patterns of windows (24) of the two circuits are coincident with each other when the flat circuits are overlapped with each other and with the circuits oriented so that the conductors of the circuits are at angles relative to each other. The conductors (18) of the respective circuits (12,14) are electrically connected through the windows.

## Description

### Field of the Invention

This invention generally relates to the art of electrical interconnections and, particularly, to a system and method for electrically interconnecting the conductors of flat flexible circuits, such as flat-conductor cable or flexible printed circuit, without the use of connectors.

### Background of the Invention

A flat-conductor cable conventionally includes an elongated flat flexible dielectric substrate having laterally spaced, generally parallel strips or conductors on one or both sides thereof. The conductors typically are covered with a thin, flexible protective layer or film on one or both sides of the cable. If protective layers or films are used, cutouts are formed transversely of the cable to expose the underlying conductors typically at the ends of the circuit where the conductors are to engage the conductors or terminals of a complementary mating connecting device which may be a second, generally parallel flat conductor cable, flexible circuit board, a printed circuit board, discrete electrical wires or the terminals of a mating connector.

The laterally spaced, generally parallel conductors of a flat conductor cable or other flat flexible circuit typically are in a given order from one side or edge of the cable to the other side or edge thereof. If that cable is to be connected to a second flat conductor cable, the two cables are interconnected generally parallel to each other, and the order of the conductors is the same from one cable to the other cable. However, there are applications wherein it is desirable or necessary to interconnect a pair of flat conductor cables wherein the order of the conductors of the respective cables are different. For instance, assuming a given cable has conductors ordered 1, 2, 3, 4, 5, 6, and that cable is to be interconnected with a second cable in a different order of conductors, such 1, 5, 3, 6, 2, 4, various relatively expensive "detangling" systems are used. Such systems may include slitting the films or protective layers of the cable and reordering and interconnecting the respective conductors. Multiple layer flexible printed circuits may be employed. Of course, separate electrical connectors may be employed to interconnect a pair of cables with the respective conductors thereof out of order relative to each other. All of these systems or processes create fabrication problems and are relatively expensive. There is a need for a system to avoid the complications and costs of the prior art. The present invention is directed to satisfying that need and solving the problems of changing the conductor order when interconnecting a pair of flat flexible circuits, such as flat conductor cables. In fact, the system of the invention is so remarkably simple that little or no additional costs are involved from the conventional preparation of flat flexible circuits used for interconnection by extraneous connecting devices.

### Summary of the Invention

An object, therefore, of the invention is to provide a new and improved system for interconnecting the generally parallel conductors of a pair of flat flexible circuits out of sequential order relative to each other.

Another object of the invention is to provide a method of changing the conductor order of a pair of interconnected flat flexible circuits.

In the exemplary embodiment of the invention, a first flat flexible circuit has a plurality of generally parallel conductors covered by a dielectric film, with a pattern of windows in the film to selectively expose the conductors at different locations longitudinally thereof. A second flat flexible circuit has a plurality of generally parallel conductors covered by a dielectric film, with a pattern of windows in the film to selectively expose the conductors at different locations longitudinally thereof. The patterns of windows in the films of the two flat flexible circuits are coincident with each other when the flexible circuits are overlapped and with the circuits oriented so that the conductors of the circuits are at angles relative to each other. Connecting means then electrically interconnect the conductors through the windows.

Although the flexible circuits may be printed circuit boards, flexible printed circuits or the like, the flat circuits herein are shown as elongated flat conductor cables. The connecting means for electrically interconnecting the conductors through the patterns of windows may comprise solder, for instance. Other connecting means such as conductive adhesives, ultrasonic welds or the like may also be used.

Other objects, features and advantages of the invention will be apparent from the following detailed description taken in connection with the accompanying drawings.

### Brief Description of the Drawings

The features of this invention which are believed to be novel are set forth with particularity in the appended claims. The invention, together with its objects and the advantages thereof, may be best understood by reference to the following description taken in conjunction with the accompanying drawings, in which like reference numerals identify like elements in the figures and in which:
FIGURE 1 is a perspective view of a pair of flat flexible circuits prepared for interconnection according to the invention;
FIGURE 2 is an enlarged section taken generally along line 2-2 in Figure 1; and
FIGURE 3 is a view similar to that of Figure 1, with the two flat flexible circuits interconnected.

### Detailed Description of the Preferred Embodiment

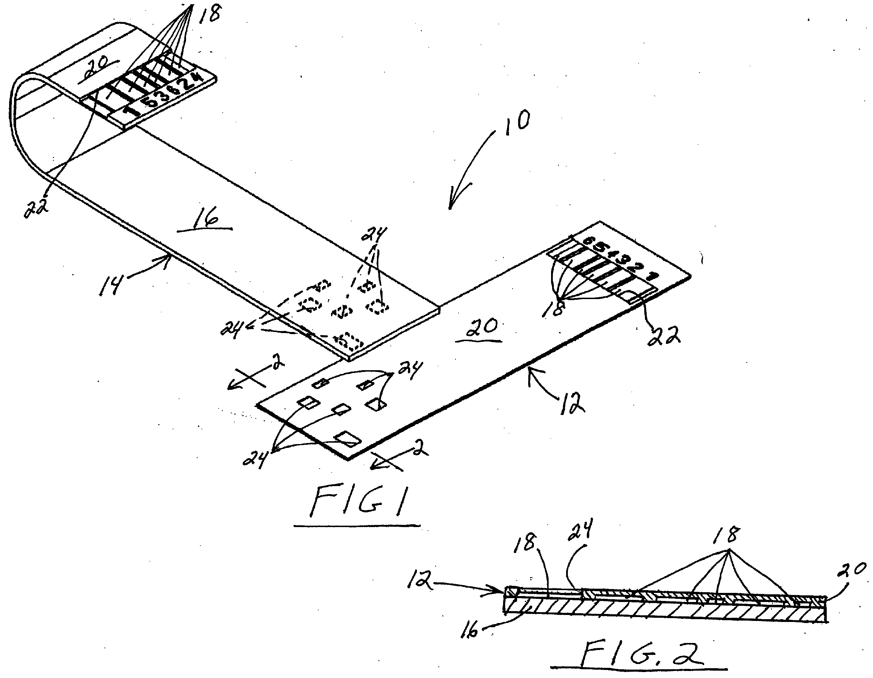

Referring to the drawings in greater detail, and first to Figure 1, the invention is embodied in a system, generally designated 10, for interconnecting the generally parallel conductors of a pair of flat flexible circuits out of sequential order relative to each other. Figure 1 shows a first flat flexible circuit, generally designated 12, prepared for and about to be interconnected to a second flat flexible circuit, generally designated 14. The circuits will be interconnected at angles to each other. In the illustrated embodiment, the circuits are interconnected at right angles to each other.

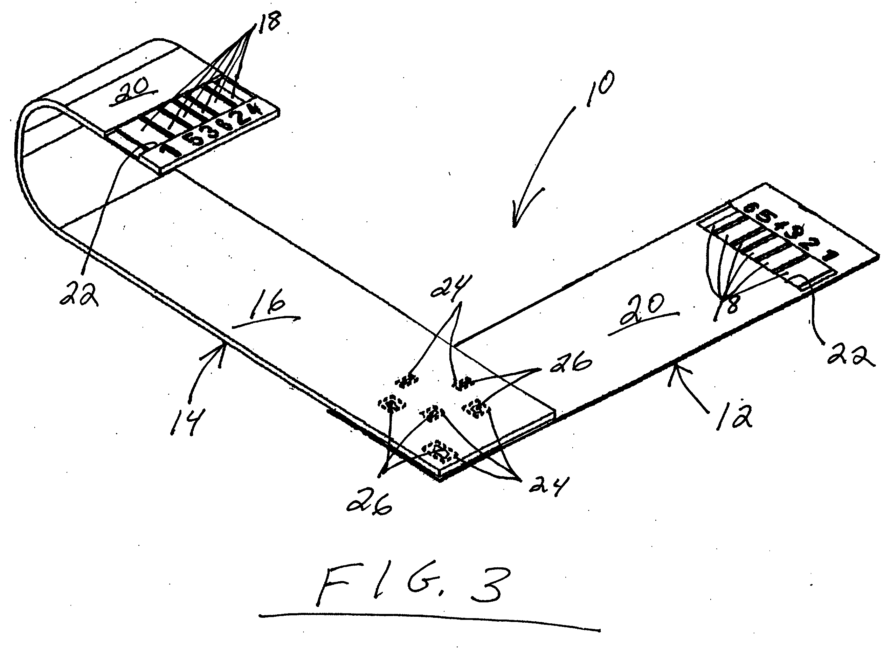

Referring to Figure 2 in conjunction with Figure 1, first flat flexible circuit 12 will be described, it being understood that second flat flexible circuit 14 is similarly constructed. In particular, each flat flexible circuit includes an elongated flat flexible dielectric substrate 16 (Fig. 2) having a plurality of laterally spaced, parallel strips or conductors 18 on a top side thereof. The conductors run parallel to each other longitudinally of the elongated substrate. A dielectric protective layer or film 20 is disposed on top of the conductors. As seen in Figure 1, a transverse cutout 22 is made in film 20 across the entire width of the circuit to expose conductors 18 for engagement by the conductors or terminals of a complementary mating connecting device (not shown). It can be seen in Figure 1 that conductors 18 have varying widths and, therefore, different electrical characteristics. Consequently, the conductors are in a specific order transversely of the circuit as indicated by numerals 1, 2, 3, 4, 5, 6 along cutout 22. These order numbers may or may not be indicated directly on the circuit, but they are shown in the drawings to facilitate a better understanding of the invention.

The invention contemplates that a pattern of windows 24 be cut or punched in film 20 according to a given connection scheme for interconnecting conductors 18 of first circuit 12 with conductors 18 of second circuit 14. The pattern of windows can be cut or punched in film 20 prior to laminating the film onto conductors 18 and substrate 16 as shown in Figure 2.

As stated above, the structure of second flat flexible circuit 14 is similar to the first circuit including flat flexible dielectric substrate 16, conductors 18 and protective layer or film 20. It is noted also that it is necessary for the invention that only one of the two flexible circuits have the windows formed therein. The mating flexible circuit may have the entire conductor area bared, that is the entire interconnect area may be cut out, thereby only using one layer of dielectric between the conductors to prevent shorting thereof. However, it should be noted that conductors 18 of second circuit 14 in Figure 1 are in an order indicated by order numbers 1, 5, 3, 6, 2, 4 which is different from the order of the conductors of first circuit 12. It should be noted that the widths of the numbered conductors of the second circuit are the same as the respective same numbered conductors of the first circuit. In other words, it can be seen that conductors "1" of both circuits are wide conductors and conductors "6" of both circuits are narrow conductors. In order to interconnect the reordered conductors of the two circuits, an identical pattern of windows 24 is cut in film 20 of second circuit 14 to precisely overlap the windows in film 20 of first circuit 12 when the two circuits are juxtaposed at angles to each other. In other words, windows 24 of second circuit 14 are coincident with windows 24 of first circuit 12 when the two circuits are overlapped with each other as shown in Figure 1, and with the second circuit extending generally perpendicular to the first circuit, as shown.

Figure 3 shows first and second flat flexible circuits 12 and 14, respectively, juxtaposed perpendicular to each other so that windows 24 in film 20 of second circuit 14 overlie windows 24 in film 20 of first circuit 12. When so juxtaposed, the respective conductors 18 of the two circuits can be electrically connected through the windows by various connecting means 26. For instance, the conductors can be soldered through the windows. A conductive adhesive may be employed to electrically connect the conductors through the windows. Ultrasonic welding may be employed to join or bond the conductors through the windows.

As stated in the "Background", above, the interconnection system of the invention involves little or no additional expenses in preparing flat circuits 12 and 14 for interconnection other than processes already used in fabricating the circuits. In other words, as stated above, cutouts 22 are cut or punched in film 20 of the circuits in order to engage conductors 18 with the conductors or terminals of a complementary mating connecting device. Therefore, windows 24 can be cut or punched in desired "reordering" patterns at the same time that cutouts 22 are formed, i.e., without adding to the fabrication costs of the circuits.

It will be understood that the invention may be embodied in other specific forms without departing from the spirit or central characteristics thereof. The present examples and embodiments, therefore, are to be considered in all respects as illustrative and not restrictive, and the invention is not to be limited to the details given herein.

## Claims

1. A system (10) for interconnecting the generally parallel conductors (18) of a pair of flat circuits (12,14) out of sequential order relative to each other, comprising:
a first flat circuit (12) having a plurality of generally parallel conductors (18) covered by a dielectric film (20), with a pattern of windows (24) in the film to selectively expose the conductors at different locations longitudinally thereof;
a second flat circuit (14) having a plurality of generally parallel conductors (18) covered by a dielectric film (20), with a pattern of windows (24) in the film to selectively expose the conductors at different locations longitudinally thereof;
said patterns of windows (24) being coincident with each other with the flat circuits (12,14) overlapping each other and with the circuits oriented so that the conductors (18) of the circuits are at angles relative to each other; and
connecting means (26) electrically interconnecting the conductors through said windows.

2. The system of claim 1 wherein at least one of said flat circuits comprises a flat flexible circuit (12,14).

3. The system of claim 1 wherein said connecting means (26) comprises said connecting means comprises solder.

4. The system of claim 1 wherein said connecting means (26) comprises ultrasonic welds.

5. The system of claim 1 wherein said connecting means (26) comprises conductive adhesive.

6. A system (10) for interconnecting the generally parallel conductors (18) of a pair of flat circuits (12,14) out of sequential order relative to each other, comprising:
a first flat circuit (12) having a plurality of generally parallel first conductors (18) covered by a first dielectric film (20);
a second flat circuit (14) having a plurality of generally parallel second conductors (18) covered by a second dielectric film (20);
at least one pattern of windows (24) in one of the first and second dielectric films to selectively expose the conductors at different locations longitudinally thereof wherein the conductors of the other of the first and second conductors are also exposed;
said flat circuits (12,14) overlapping each other and with the circuits oriented so that the conductors (18) of the circuits are at angles relative to each other; and
connecting means (26) electrically interconnecting the conductors through said windows.

7. The system of claim 1 wherein at least one of said flat circuits comprises a flat flexible circuit (12,14).

8. The system of claim 1 wherein said connecting means (26) comprises solder.

9. The system of claim 1 wherein said connecting means (26) comprises ultrasonic welds.

10. The system of claim 1 wherein said connecting means (26) comprises conductive adhesive.
